# EUROPÄISCHE PATENTSCHRIFT

(11) **EP 3 711 075 B1**
(45) Veröffentlichungstag und Bekanntmachung des Hinweises auf die Patenterteilung: **28.12.2022**
(21) Anmeldenummer: 18800628.2
(22) Anmeldetag: 09.11.2018
(51) Int. Cl.: H01H 9/54, H02H 7/22, H01L 23/053, H05K 5/00

(54) **MECHATRONIKBAUGRUPPE MIT EINER HYBRIDEN SCHALTUNGSANORDNUNG**
MECHATRONIC MODULE HAVING A HYBRID CIRCUIT ARRANGEMENT
COMPOSANT MÉCATRONIQUE AVEC CIRCUIT HYBRIDE

(30) Priorität: 17.11.2017 DE 102017127076
(43) Veröffentlichungstag der Anmeldung: 23.09.2020
(73) Patentinhaber: Eaton Intelligent Power Limited, Dublin 4 (IE)
(72) Erfinder: ASKAN, Kenan, 1090 Vienna (AT)
(74) Vertreter: Eaton IP Group EMEA
(86) Internationale Anmeldenummer: PCT/EP2018/080778
(87) Internationale Veröffentlichungsnummer: WO 2019/096692

(56) Entgegenhaltungen:
- EP-A2- 2 782 131
- WO-A1-2015/028634
- US-A1- 2009 161 277
- US-A1- 2010 127 371

## Beschreibung

Die Erfindung betrifft eine Mechatronikbaugruppe gemäß Patentanspruch 1.

Es sind sog. hybride Schaltgeräte bekannt, welche sowohl mechanische Schalter als auch Halbleiterschalter aufweisen. Ein derartiges Schaltgerät ist etwa aus der WO 2015/028634 A1 bekannt. Derartige Schaltgeräte weisen erhebliche Unterschiede zu rein mechanischen Schaltgeräten auf, welche - in der Praxis - zu gänzlich unterschiedlichen Anforderungen hinsichtlich des elektromechanischen Aufbaus führen.

Bei hybriden Schaltgeräten liegen in der Regel mehrere mechanische Kontaktpaare seriell im Strompfand durch das Schaltgerät. Dies hat oftmals einen höheren Widerstand und eine höhere Eigenerwärmung zur Folge. Gleichzeitig sind Leistungshalbleiter zentrale Komponenten, die für ein Abschalten der Ströme durch das hybride Schaltgerät unerlässlich sind. Hohe Umgebungstemperaturen vermindern jedoch die Lebensdauer von Halbleiterschaltern. Ein Ausfall der Halbleiterschalter würde bedeuten, dass ein Strom lediglich durch das, parallel zu den Halbleiterschaltern angeordnete Bypassrelais ausgeschaltet werden müsste, welches dazu schlichtweg nicht ausgelegt ist, und welchem auch keine Lichtbogenlöscheinrichtung zugeordnet ist. Das Bypassrelais wird ohne funktionierende Halbleiterschalter beim Versuch einen hohen Strom abzuschalten, etwa einen Kurzschlussstrom in einer typischen Niederspannungs-Installationsumgebung, explosionsartig zerstört.

Weiters können unterschiedliche Temperaturniveaus innerhalb des Schaltgeräts zu einer Beeinträchtigung der Funktion des hybriden Schaltgerätes führen.

Es hat sich weiters gezeigt, dass der tatsächliche elektromechanische Aufbau in ganz erheblicher Weise die Funktionsfähigkeit der hybriden Schaltungsanordnung, insbesondere deren Fähigkeit Kurzschlussströme mit einigen tausend Ampere sicher abzuschalten, beeinflusst.

Die US 2009/161277 A1 beschreibt ein Halbleitermodul, welches vor allem als Brückenschaltungsmodul, etwa für Inverteranwendungen, ausgebildet ist, wobei seriell zu einem Brückenzweig ein MEMS-Schalter angeordnet ist. MEMS steht dabei für Micro Electromechanical System. Der MEMS-Schalter soll in 20 µs öffnen. Die Komponenten sind zusammen auf einem Keramiksubstrat angeordnet. Der MEMS-Schalter dient lediglich dem internen Schutz der Halbleiter selbst. Der MEMS-Schalter bildet jedoch zusammen mit den IGBT keine Schutzanordnung für andere Geräte bzw. Anlagen. Die Anordnung gemäß der US 2009/161277 A1 ist nicht dazu geeignet Kurzschlussströme, welche typischerweise einige tausend Ampere betragen, abzuschalten.

Die EP 2 782 131 A2 beschreibt ein Leistungshalbleitermodul mit einem Kühlkörper.

Aufgabe der Erfindung ist es daher eine Mechatronikbaugruppe der eingangs genannten Art anzugeben, mit welchem die genannten Nachteile hybrider Schaltgeräte vermieden werden können, und mit welchem über lange Zeit eine elektrische Absicherung gewährleistet werden kann.

Erfindungsgemäß wird dies durch die Merkmale des Patentanspruches 1 erreicht. Dadurch kann sicher über eine lange Zeit eine elektrische Absicherung gewährleistet werden. Dadurch kann im Falle eines Ausfalls der ersten Halbleiterschaltungsanordnung die Umgebung sicher vor den Folgen einer Zerstörung des mechanischen Schalters geschützt werden. Durch die Ankoppelung an die Metallplatte kann innerhalb der Mechatronikbaugruppe eine ausgeglichene Temperatur erreicht werden. Die nach Außen freie Fläche der Metallplatte kann gut Wärme an die Umgebung abgeben. Durch die Summe der gegenständlichen Maßnahmen kann ein realer Aufbau einer hybriden Schaltungsanordnung geschaffen werden, welcher langlebig und funktionssicher ist.

Die Unteransprüche betreffen weitere vorteilhafte Ausgestaltungen der Erfindung. Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 einen Stromlaufplan einer Ausführungsform einer gegenständlichen hybriden Schaltungsanordnung;
Fig. 2 eine gegenständliche Mechatronikbaugruppe ohne Gehäuseschale in axonometrischer Darstellung;
Fig. 3 die Mechatronikbaugruppe gemäß Fig. 2 im Grundriss; und die
Fig. 4 die Mechatronikbaugruppe gemäß Fig. 2 mit geschlossenem Gehäuse in axonometrischer Darstellung.

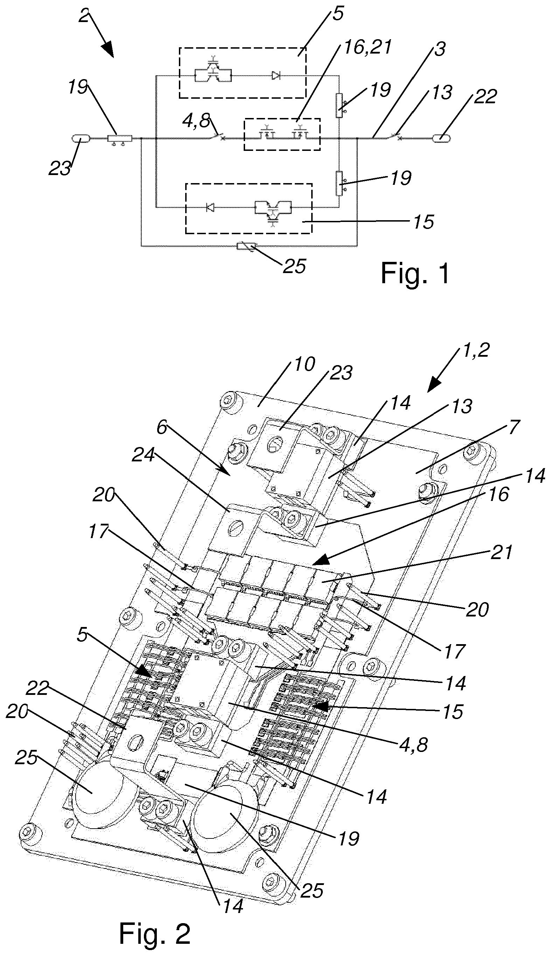

Fig. 1 zeigt einen Stromlaufplan einer hybriden Schaltungsanordnung 2, wie diese insbesondere als Teil eines hybriden Schutzschalters, insbesondere eines Niederspannungs-Schutzschaltgerät, vorgesehen ist. Der konkrete und nachfolgend beschriebene Schaltungsaufbau ist ein Beispiel, wobei auch hievon abweichende Arten hybrider Schaltungsanordnung vorgesehen sein können, insbesondere wenn diese als Hauptschaltstrecke eines Schutzschalters geeignet sind.

Die gegenständliche hybride Schaltungsanordnung 2 weist wenigstens eine Schaltstrecke 3 auf, wobei auch weitere Schaltstrecken vorgesehen sein können. Es kann vorgesehen sein, dass Schaltstrecken für Außenleiter unterschiedlich zu Schaltstrecken für Neutralleiter ausgebildet und/oder betrieben werden.

In der ersten Schaltstrecke 3 ist ein erster mechanischer Schalter 4 angeordnet, welcher bei dem gegenständlichen Schaltungslayout als Bypassschalter 8 bezeichnet werden kann. Schaltungstechnisch parallel zu dem ersten Schalter 4 ist eine erste Halbleiterschaltungsanordnung 5 angeordnet, welche Leistungshalbleiterschaltelemente, etwa IGBT, umfasst. Gemäß der besonders bevorzugten Ausführungsform ist weiters eine zweite Halbleiterschaltungsanordnung 15 parallel zum Bypassschalter 8 geschaltet, welche ebenfalls entsprechende Leistungshalbleiterschaltelemente aufweist. Dabei ist bevorzugt vorgesehen, dass eine Durchflussrichtung der zweiten Halbleiterschaltungsanordnung 15 entgegengesetzt einer Durchflussrichtung der ersten Halbleiterschaltungsanordnung 5 ist.

Parallel zu dieser Schaltanordnung ist ein Varistor 25 angeordnet.

Der hybriden Schaltungsanordnung 2 ist eine elektronische Steuereinheit 26 zugeordnet, welche jedoch außerhalb der gegenständlichen Mechatronikbaugruppe 1 angeordnet ist. Diese dient der Ansteuerung der mechanischen und der elektrischen Schalter. Die elektronische Steuereinheit 26 ist bevorzugt außen an der Gehäuseschale 11 angeordnet.

Die hybride Schaltungsanordnung 2 weist wenigstens einen Shunt 19 einer Strommessanordnung auf. Die gegenständlich dargestellte Ausführungsform weist drei Shunts 19 auf.

Die hybride Schaltungsanordnung 2 weist weiters bevorzugt einen zweiten mechanischen Schalter 13 auf, welcher bei der gegenständlichen Ausführungsform zur galvanischen Trennung nach erfolgter Abschaltung dient.

Die hybride Schaltungsanordnung 2 kann auch gänzlich abweichend ausgebildet sein, wobei der eigentliche Abschaltvorgang des Stromes gänzlich ohne mechanischem Schalter erfolgt, wobei dann der Bypassschalter 8 entfällt. Bei derartigen sog. Solid State Circuit Breakern übernimmt der erste mechanische Schalter 4 die Funktion der galvanischen Trennung, welche gemäß Fig. 1 vom zweiten mechanischen Schalter 13 erfüllt wird.

Weiters weist die hybride Schaltungsanordnung 2 bevorzugt eine dritte Halbleiterschaltungsanordnung 16 auf, welche umfassend MosFETs 21 ausgebildet ist, und welche seriell zum ersten mechanischen Schalter 4 und parallel zur ersten Halbleiterschaltungsanordnung 5 geschaltet ist. Diese dritte Halbleiterschaltungsanordnung 16 ermöglicht ein Trennen der Kontakte des Bypassschalters 8 ohne Lichtbögen, ist jedoch beim Konzept gemäß Fig. 1 nicht zwingend erforderlich.

Die Fig. 2 bis 4 zeigen jeweils unterschiedliche Ansichten einer Mechatronikbaugruppe 1 mit einer hybriden Schaltungsanordnung 2, wie diese vorstehend beispielhaft beschrieben ist, welche jedoch jedenfalls wenigstens eine Schaltstrecke 3 mit einem ersten mechanischen Schalter 4 und einer erste Halbleiterschaltungsanordnung 5 aufweist. Weiters zeigen die entsprechenden Figuren die optionale zweite Halbleiterschaltungsanordnung 15. Die hybride Schaltungsanordnung 2 ist an einer ersten Fläche 6 eines Keramiksubstrats 7, etwa Al₂O₃ oder AlN, angeordnet. Dabei kann das Keramiksubstrat 7 auch lediglich ein Teil eines größeren Bauteilträgers sein.

Die, der ersten Fläche 7 gegenüber liegende zweite Fläche des Keramiksubstrats 7 ist mit einer Metallplatte 10, insbesondere einer Kupferplatte, Aluminiumplatte oder Silberplatte, verbunden. Besonders bevorzugt ist vorgesehen, dass die Metallplatte 10 an einer, dem Keramiksubstrat 7 abgewandten Fläche mit einem Kühlkörper verbunden ist.

Bevorzugt ist vorgesehen, dass das Keramiksubstrat 7 im Wesentlichen vollflächig mit der Metallplatte 10 verbunden. Dabei ist weiters vorgesehen, dass das Keramiksubstrat 7 im Wesentlichen direkt mit der Metallplatte 10 verbunden ist, wobei zwischen diesen eine Wärmeleitpaste oder ähnliches angeordnet sein kann.

Weiters kann vorgesehen sein, dass die Metallplatte 10 Teil eines Kühlkörpers ist.

An der Metallplatte 10 ist eine Gehäuseschale 11 befestigt, welche das Keramiksubstrat 7 und die hybride Schaltungsanordnung 2 umschließt, wobei die Metallplatte 10 und die Gehäuseschale 11 derart ein Gehäuse 12 der Mechatronikbaugruppe 1 bilden. Die Gehäuseschale 11 ist bevorzugt aus einem elektrisch isolierenden Kunststoff gebildet. Bevorzugt ist die Gehäuseschale 11 mit der Metallplatte 10 verschraubt.

Zwischenräume innerhalb des Gehäuses 12 sind wenigstens bereichsweise mit einer Vergussmasse gefüllt, wobei insbesondere vorgesehen ist, dass diese Zwischenräume mittels SilGel verfüllt sind, wobei jedoch auch andere Vergussmassen, etwa auf Epoxid-Basis vorgesehen sein können. Weiters ist bevorzugt ein Vakuumverguss vorgesehen.

Wie im einleitenden Teil bereist angeführt, ist die tatsächliche Anordnung der Bauteile sowie die Konzeption des elektromechanischen Aufbaus wichtig für das Funktionieren der hybriden Schaltungsanordnung 2 in der Realität. Die nachfolgend beschriebenen Maßnahmen haben sich diesbezüglich als sehr vorteilhaft erwiesen.

Bevorzugt ist vorgesehen, dass der erste mechanische Schalter 4, welcher bevorzugt als Bypassschalter 8 ausgebildet ist, im Bereich einer Mitte des Keramiksubstrats 7 auf dem Keramiksubstrat 7 angeordnet ist. Dadurch ist es möglich die weiteren Komponenten um diesen zentralen Bauteil herum anzuordnen. Dies hat sich als wichtig bzw. vorteilhaft erwiesen, da dadurch die Leitungslängen kurz gehalten werden können, und vor allem da dadurch die Schleifeninduktanz einzelner Schaltungsteile sehr kurz gehalten werden kann. Als Mitte wird dabei insbesondere der Bereich entlang einer Symmetrieachse des Keramiksubstrats 7 bezeichnet.

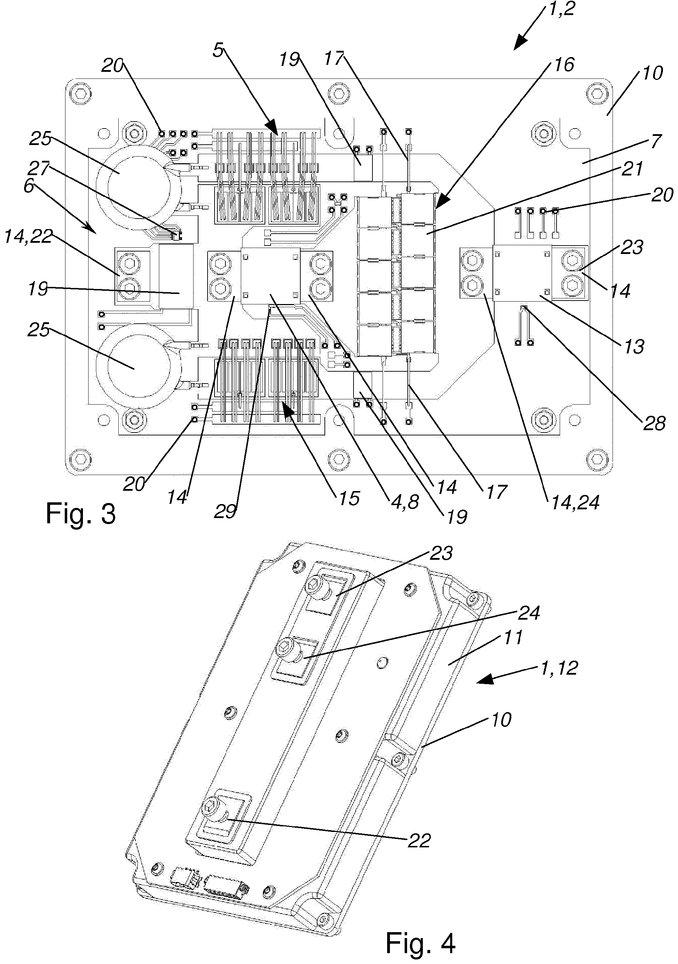

Sofern die hybride Schaltungsanordnung 2 weiters einen zweiten mechanischen Schalter 13 aufweist, ist bevorzugt vorgesehen, dass dieser - wie etwa in Fig. 3 zu erkennen - in einer Linie mit dem ersten mechanischen Schalter 4 angeordnet ist.

Der oder die Schalter 4, 8, 13 sind bevorzugt nicht direkt auf dem Keramiksubstrat 7 abgeordnet. Bevorzugt ist dabei vorgesehen, dass auf dem Keramiksubstrat 7 eine vorgebbare Anzahl elektrisch leitender Befestigungsblöcke 14, insbesondere Metallblöcke, vorzugsweise Kupferblöcke, angeordnet sind, und dass der erste mechanische Schalter 4 und/oder der zweite mechanische Schalter 13 an den Befestigungsblöcken 14 befestigt sind. Weiters sind auch die Anschlussklemmen 22, 23, 24 an derartigen Befestigungsblöcken 14 angeordnet bzw. befestigt.

Die Anschlussklemmen 22, 23, 24 sind bevorzugt entlang einer Reihe angeordnet, was es einfach möglich macht mehrere gleichartige Mechatronikbaugruppen 1 parallel zu schalten.

Derartige Befestigungsblöcke 14 ermöglichen eine sichere Montage der Schalter 4, 8, 13 und Anschlussklemmen 22, 23, 24. Insbesondere ermöglichen diese eine genaue Positionierung des Bypassschalters 8, bei welchem es sich um einen Präzisionsschalter handelt. Durch die Befestigung auf den Befestigungsblöcken 14 kann vermieden werden, dass der Bypassschalter 8 - wie etwa bei der Befestigung mittels Löten - zu stark erwärmt und dadurch in Mitleidenschaft gezogen wird. Weiters kann verhindert werden, dass sich dieser verzieht. Dabei ist besonders bevorzugt vorgesehen, dass der erste mechanische Schalter 4 und/oder der zweite mechanische Schalter 13 an den Befestigungsblöcken 14 angeschraubt sind.

Die erste Halbleiterschaltungsanordnung 5 und die zweite Halbleiterschaltungsanordnung 15, welche bevorzugt umfassend IGBTs und serielle Blocking Dioden ausgebildet sind, sind, wie in Fig. 1 dargestellt, parallel geschaltet, und wie in Fig. 2 und 3 dargestellt, bevorzugt symmetrisch beidseitig des ersten mechanischen Schalters 4 angeordnet.

Die dritte Halbleiterschaltungsanordnung 16 ist bevorzugt zwischen dem ersten und zweiten Schalter 4, 13 angeordnet. Die dritte Halbleiterschaltungsanordnung 16 ist umfassend MosFets 21 ausgebildet. Bei den Leitungen 17 handelt es sich um Steueranschlüsse der MosFets 21.

Es hat sich als besonders vorteilhaft erwiesen, dass ein MosFet 21 der dritten Halbleiterschaltungsanordnung 16 als Schmelzsicherung 18 ausgebildet ist. Dies ist derart zu verstehen, dass wenigstens ein MosFet 21 die Funktion einer Schmelzsicherung übernimmt, und bei einer entsprechenden Überlast zerstört wird, woraufhin die betreffende Leitung unterbrochen wird. Dadurch kann die Sicherheit der Mechatronikbaugruppe 1 weiter erhöht werden, ohne dass hiezu zusätzliche Bauteile erforderlich wären.

Weiters ist bevorzugt vorgesehen, dass die hybride Schaltungsanordnung 2 wenigstens einen Shunt 19 einer Strommessanordnung aufweist, und dass der wenigstens eine Shunt 19 als Leiterbahn, insbesondere umfassend Silber, der hybriden Schaltungsanordnung 2 ausgebildet ist. Dadurch kann auf einen diesbezüglich separaten Bauteil verzichtet werden.

Die Mechatronikbaugruppe 1 weist weiters wenigstens einen Temperatursensor 27 auf, welcher bevorzugt in räumlicher Nähe zu dem wenigstens einen Shunt 19 angeordnet ist.

Der wenigstens einen Shunt 19 kann auch zur Energiemessung verwendet werden. Der Temperatursensor 27 erlaubt, neben der allgemeinen Temperaturüberwachung weiters auch die Kalibrierung des Shunts 19. Im Bereich der ersten bzw. zweiten mechanischen Schalter 4, 13 sind bevorzugt weitere Temperatursensoren 28, 29 angeordnet, um weiters die Temperatur im Bereich der mechanischen Schalter 4, 13 zu überwachen.

Die Mechatronikbaugruppe 1 weist weiters eine vorgebbare Mehrzahl Steueranschlüsse 20 zum Verbinden der hybriden Schaltungsanordnung 2 mit einer elektronischen Steuereinheit auf.

Besonders bevorzugt ist vorgesehen, dass die Leistungsbaugruppen eines Niederspannungs-Schutzschaltgeräts in einer gegenständlichen Mechatronikbaugruppe 1 angeordnet sind.

## Patentansprüche

1. Mechatronikbaugruppe (1) mit einer hybriden Schaltungsanordnung (2), welche als Hauptschaltstrecke eines Schutzschalters ausgebildet ist, wobei die hybride Schaltungsanordnung (2) wenigstens eine Schaltstrecke (3) aufweist, welche Schaltstrecke (3) wenigstens einen ersten mechanischen Schalter (4) und wenigstens eine erste Halbleiterschaltungsanordnung (5) umfasst, wobei die hybride Schaltungsanordnung (2) an einer ersten Fläche (6) eines Keramiksubstrats (7) angeordnet ist, wobei eine, der ersten Fläche (7) gegenüber liegende, zweite Fläche des Keramiksubstrats (7) mit einer Metallplatte (10), verbunden ist, wobei an der Metallplatte (10) eine Gehäuseschale (11) befestigt ist, welche das Keramiksubstrat (7) und die hybride Schaltungsanordnung (2) umschließt, wobei die Metallplatte (10) und die Gehäuseschale (11) ein Gehäuse (12) der Mechatronikbaugruppe (1) bilden, wobei Zwischenräume innerhalb des Gehäuses (12) wenigstens bereichsweise mit einer Vergussmasse gefüllt sind, **dadurch gekennzeichnet, dass** der erste mechanische Schalter (4) als Bypassschalter (8) ausgebildet ist, welcher schaltungstechnisch parallel zur ersten Halbleiterschaltungsanordnung (5) angeordnet ist, dass der erste Schalter (4) im Bereich einer Mitte des Keramiksubstrats (7) auf dem Keramiksubstrat (7) angeordnet ist, dass auf dem Keramiksubstrat (7) eine vorgebbare Anzahl elektrisch leitender Befestigungsblöcke (14) angeordnet sind, und dass der erste mechanische Schalter (4) an den Befestigungsblöcken (14) befestigt ist.

2. Mechatronikbaugruppe (1) nach Anspruch 1, **dadurch gekennzeichnet, dass** das Keramiksubstrat (7) im Wesentlichen vollflächig mit der Metallplatte (10) verbunden ist.

3. Mechatronikbaugruppe (1) nach Anspruch 1 oder 2, **dadurch gekennzeichnet, dass** die Metallplatte (10) an einer, dem Keramiksubstrat (7) abgewandten Fläche mit einem Kühlkörper verbunden ist.

4. Mechatronikbaugruppe (1) nach einem der Ansprüche 1 bis 3, **dadurch gekennzeichnet, dass** die Befestigungsblöcke (14) als Kupferblöcke ausgebildet sind.

5. Mechatronikbaugruppe (1) nach einem der Ansprüche 1 bis 4, **dadurch gekennzeichnet, dass** die hybride Schaltungsanordnung (2) weiters einen zweiten mechanischen Schalter (13) aufweist, welcher seriell sowohl zum ersten mechanischen Schalter (4) als auch der ersten Halbleiterschaltungsanordnung (5) angeordnet ist.

6. Mechatronikbaugruppe (1) nach Anspruch 5, **dadurch gekennzeichnet, dass** der zweite mechanische Schalter (13) an den Befestigungsblöcken (14) befestigt ist.

7. Mechatronikbaugruppe (1) nach Anspruch 6, **dadurch gekennzeichnet, dass** der zweite mechanische Schalter (13) an den Befestigungsblöcken (14) angeschraubt ist.

8. Mechatronikbaugruppe (1) nach einem der Ansprüche 1 bis 7, **dadurch gekennzeichnet, dass** die hybride Schaltungsanordnung (2) weiters eine zweite Halbleiterschaltungsanordnung (15) aufweist, und dass die erste Halbleiterschaltungsanordnung (5) und die zweite Halbleiterschaltungsanordnung (15), welche bevorzugt umfassend IGBTs und serielle Blocking Dioden ausgebildet sind, parallel geschaltet und symmetrisch beidseitig des ersten mechanischen Schalters (4) angeordnet sind.

9. Mechatronikbaugruppe (1) nach einem der Ansprüche 1 bis 8, **dadurch gekennzeichnet, dass** die hybride Schaltungsanordnung (2) eine dritte Halbleiterschaltungsanordnung (16) aufweist, welche umfassend MosFETs (21) ausgebildet ist, und welche seriell zum ersten mechanischen Schalter (4) und parallel zur ersten Halbleiterschaltungsanordnung (5) geschaltet ist.

10. Mechatronikbaugruppe (1) nach Anspruch 9, **dadurch gekennzeichnet, dass** ein MosFet (21) der dritten Halbleiterschaltungsanordnung (16) als Schmelzsicherung ausgebildet ist.

11. Mechatronikbaugruppe (1) nach einem der Ansprüche 1 bis 10, **dadurch gekennzeichnet, dass** die hybride Schaltungsanordnung (2) wenigstens einen Shunt (19) einer Strommessanordnung aufweist, und dass der wenigstens eine Shunt (19) als Leiterbahn, insbesondere umfassend Silber, der hybriden Schaltungsanordnung (2) ausgebildet ist.

12. Mechatronikbaugruppe (1) nach Anspruch 11, **dadurch gekennzeichnet, dass** in räumlicher Nähe zu dem wenigstens einen Shunt (19) wenigstens ein Temperatursensor der Mechatronikbaugruppe (1) angeordnet ist.

13. Mechatronikbaugruppe (1) nach einem der Ansprüche 1 bis 12, **dadurch gekennzeichnet, dass** die Mechatronikbaugruppe (1) eine vorgebbare Mehrzahl Steueranschlüsse (20) zum Verbinden der hybriden Schaltungsanordnung (2) mit einer elektronischen Steuereinheit aufweist.

14. Niederspannungs-Schutzschaltgerät umfassend wenigstens eine Mechatronikbaugruppe (1) nach einem der Ansprüche 1 bis 13.

## Claims

1. Mechatronic module (1) having a hybrid circuit arrangement (2) which is designed as a main interrupter of a circuit breaker, the hybrid circuit arrangement (2) having at least one interrupter (3), which interrupter (3) comprises at least one first mechanical switch (4) and at least one first semiconductor circuit arrangement (5), the hybrid circuit arrangement (2) being arranged on a first surface (6) of a ceramic substrate (7), a second surface of the ceramic substrate (7) lying opposite the first surface (7) being connected to a metal plate (10), a housing shell (11) being attached to the metal plate (10), said housing shell enclosing the ceramic substrate (7) and the hybrid circuit arrangement (2), the metal plate (10) and the housing shell (11) forming a housing (12) of the mechatronic module (1), gaps within the housing (12) being filled, at least in regions, with a potting compound, **characterized in that** the first mechanical switch (4) is designed as a bypass switch (8) which is arranged in parallel to the first semiconductor circuit arrangement (5) in terms of circuitry, the first switch (4) is arranged on the ceramic substrate (7) in the region of a center of the ceramic substrate (7), a predeterminable number of electrically conductive mounting blocks (14) are arranged on the ceramic substrate (7), and the first mechanical switch (4) is attached to the mounting blocks (14).

2. Mechatronic module (1) according to claim 1, **characterized in that** substantially the entire surface of the ceramic substrate (7) is connected to the metal plate (10).

3. Mechatronic module (1) according to claim 1 or 2, **characterized in that** the metal plate (10) is connected to a heat sink on a surface facing away from the ceramic substrate (7).

4. Mechatronic module (1) according to any of claims 1 to 3,
**characterized in that** the mounting blocks (14) are designed as copper blocks.

5. Mechatronic module (1) according to any of claims 1 to 4,
**characterized in that** the hybrid circuit arrangement (2) further comprises a second mechanical switch (13) which is arranged in series with both the first mechanical switch (4) and the first semiconductor circuit arrangement (5).

6. Mechatronic module (1) according to claim 5, **characterized in that** the second mechanical switch (13) is attached to the mounting blocks (14).

7. Mechatronic module (1) according to claim 6, **characterized in that the** second mechanical switch (13) is screwed to the mounting blocks (14).

8. Mechatronic module (1) according to any of claims 1 to 7,
**characterized in that** the hybrid circuit arrangement (2) further has a second semiconductor circuit arrangement (15), and the first semiconductor circuit arrangement (5) and the second semiconductor circuit arrangement (15), which are preferably designed to comprise IGBTs and serial blocking diodes, are connected in parallel and arranged symmetrically on both sides of the first mechanical switch (4).

9. Mechatronic module (1) according to any of claims 1 to 8,
**characterized in that** the hybrid circuit arrangement (2) has a third semiconductor circuit arrangement (16) which is designed to comprise MosFets (21), and which is connected in series to the first mechanical switch (4) and in parallel to the first semiconductor circuit arrangement (5).

10. Mechatronic module (1) according to claim 9, **characterized in that** a MosFet (21) of the third semiconductor circuit arrangement (16) is designed as a fuse.

11. Mechatronic module (1) according to any of claims 1 to 10,
**characterized in that** the hybrid circuit arrangement (2) has at least one shunt (19) of a current-measuring arrangement, and the at least one shunt (19) is designed as a conductor track, in particular comprising silver, of the hybrid circuit arrangement (2).

12. Mechatronic module (1) according to claim 11, **characterized in that** at least one temperature sensor of the mechatronic module (1) is arranged in spatial proximity to the at least one shunt (19).

13. Mechatronic module (1) according to any of claims 1 to 12,
**characterized in that** the mechatronic module (1) comprises a predeterminable plurality of control terminals (20) for connecting the hybrid circuit arrangement (2) to an electronic control unit.

14. Low-voltage circuit protection device comprising at least one mechatronic module (1) according to any of claims 1 through 13.

## Revendications

1. Ensemble mécatronique (1) comportant un agencement de circuit hybride (2) qui est réalisé en tant que section de commutation principale d'un commutateur de protection, l'agencement de circuit hybride (2) présentant au moins une section de commutation (3), laquelle section de commutation (3) comprenant au moins un premier commutateur mécanique (4) et au moins un premier agencement de circuit à semi-conducteurs (5), l'agencement de circuit hybride (2) étant disposé sur une première surface (6) d'un substrat céramique (7), une seconde surface du substrat céramique (7) opposée à la première surface (7) étant reliée à une plaque métallique (10), une coque de boîtier (11) étant fixée à la plaque métallique (10) et entourant le substrat céramique (7) et l'agencement de circuit hybride (2), la plaque métallique (10) et la coque de boîtier (11) formant un boîtier (12) de l'ensemble mécatronique (1), des espaces intermédiaires à l'intérieur du boîtier (12) étant remplis, au moins dans certaines régions, d'une masse de scellement, **caractérisé en ce que** le premier commutateur mécanique (4) est réalisé en tant que commutateur de dérivation (8) qui est disposé, en termes de la technique des circuits, en parallèle avec le premier agencement de circuit à semi-conducteurs (5), **en ce que** le premier commutateur (4) est disposé sur le substrat céramique (7) dans la région d'un centre du substrat céramique (7), **en ce qu'**un nombre pouvant être prédéfini de blocs de fixation (14) électriquement conducteurs sont disposés sur le substrat céramique (7), **et en ce que** le premier commutateur mécanique (4) est fixé aux blocs de fixation (14).

2. Ensemble mécatronique (1) selon la revendication 1, **caractérisé en ce que** le substrat céramique (7) est relié sensiblement sur toute sa surface à la plaque métallique (10).

3. Ensemble mécatronique (1) selon la revendication 1 ou 2,
**caractérisé en ce que** la plaque métallique (10) est reliée à un corps de refroidissement sur une surface opposée au substrat céramique (7).

4. Ensemble mécatronique (1) selon l'une des revendications 1 à 3, **caractérisé en ce que** les blocs de fixation (14) sont réalisés en tant que blocs de cuivre.

5. Ensemble mécatronique (1) selon l'une des revendications 1 à 4, **caractérisé en ce que** l'agencement de circuit hybride (2) présente en outre un second commutateur mécanique (13) qui est disposé en série à la fois avec le premier commutateur mécanique (4) et avec le premier agencement de circuit à semi-conducteurs (5).

6. Ensemble mécatronique (1) selon la revendication 5, **caractérisé en ce que** le second commutateur mécanique (13) est fixé aux blocs de fixation (14).

7. Ensemble mécatronique (1) selon la revendication 6, **caractérisé en ce que** le second commutateur mécanique (13) est vissé sur les blocs de fixation (14).

8. Ensemble mécatronique (1) selon l'une des revendications 1 à 7, **caractérisé en ce que** l'agencement de circuit hybride (2) présente en outre un deuxième agencement de circuit à semi-conducteurs (15), **et en ce que** le premier agencement de circuit à semi-conducteurs (5) et le deuxième agencement de circuit à semi-conducteurs (15), lesquels comprennent de préférence des IGBT et des diodes de blocage en série, sont connectés en parallèle et sont disposés symétriquement des deux côtés du premier commutateur mécanique (4).

9. Ensemble mécatronique (1) selon l'une des revendications 1 à 8, **caractérisé en ce que** l'agencement de circuit hybride (2) présente un troisième agencement de circuit à semi-conducteurs (16), lequel comprend des MosFET (21) et est connecté en série avec le premier commutateur mécanique (4) et en parallèle avec le premier agencement de circuit à semi-conducteurs (5).

10. Ensemble mécatronique (1) selon la revendication 9,
**caractérisé en ce qu'**un MosFet (21) du troisième agencement de circuit à semi-conducteurs (16) est réalisé en tant que fusible.

11. Ensemble mécatronique (1) selon l'une des revendications 1 à 10, **caractérisé en ce que** l'agencement de circuit hybride (2) présente au moins un shunt (19) d'un agencement de mesure de courant, **et en ce que** l'au moins un shunt (19) est réalisé en tant que piste conductrice, en particulier comprenant de l'argent, de l'agencement de circuit hybride (2).

12. Ensemble mécatronique (1) selon la revendication 11,
**caractérisé en ce qu'**au moins un capteur de température de l'ensemble mécatronique (1) est disposé à proximité spatiale de l'au moins un shunt (19).

13. Ensemble mécatronique (1) selon l'une des revendications 1 à 12, **caractérisé en ce que** l'ensemble mécatronique (1) présente une pluralité pouvant être prédéfinie de connexions de commande (20) pour la connexion de l'agencement de circuit hybride (2) à une unité de commande électronique.

14. Appareil de commutation de protection basse tension comprenant au moins un ensemble mécatronique (1) selon l'une des revendications 1 à 13.
